# EUROPEAN PATENT APPLICATION

(11) **EP 4 701 387 A1**
(43) Date of publication of application: **25.02.2026**
(21) Application number: 25192406.4
(22) Date of filing: 29.07.2025
(51) Int. Cl.: H10K 59/80, H10K 59/131, H10K 59/124

(54) **DISPLAY APPARATUS**

(30) Priority: 23.08.2024 KR 20240113417
(71) Applicant: LG Display Co., Ltd., Seoul, 07336 (KR)
(72) Inventor: KO, Intae, 10845 Gyeonggi-do (KR); SONG, SangMoo, 10845 Gyeonggi-do (KR)
(74) Representative: Ter Meer Steinmeister & Partner

(57) **Abstract**

A display apparatus according to an embodiment of the specification may include a substrate having a notch and including a display area including a plurality of sub-pixels and a non-display area around the display area, a plurality of transistors disposed on the substrate and including a gate electrode, a source electrode, and a drain electrode, a display panel including a light-emitting portion disposed on the plurality of transistors and including an anode electrode, a cathode electrode, and a light-emitting layer between the anode electrode and the cathode electrode, and a microlens disposed on light-emitting areas of the sub-pixels, wherein a pad part and a link part may be disposed in the non-display area, and a plurality of data lines of which some are formed on different layers with an insulating layer interposed therebetween may be alternately disposed in the link part.

## Description

The application claims priority to Korean Patent Application No. 10-2024-0113417, filed August 23, 2024.

### Field of the Invention

The specification relates to a display apparatus.

### Description of the Related Art

As the information society develops, various demands for display apparatuses for displaying images are increasing, and various types of display apparatuses, such as a liquid crystal display (LCD) apparatus and an organic light emitting diode (OLED) display apparatus, are being utilized.

Among the display apparatuses, there is an advantage in that the OLED display apparatus as the self-luminous type has a wider viewing angle and a high contrast ratio, and is lighter and thinner and has less power consumption than the LCD because it does not require a separate backlight. There is an advantage in that the OLED display apparatus can be driven at a low voltage, have a fast response time, and especially have inexpensive manufacturing cost.

The OLED display apparatus can also be applied to display apparatuses mounted on vehicles. Among display apparatuses installed on a vehicle, display apparatuses in front of a driver's seat and a front passenger's seat need to limit or control a viewing angle of a driver according to driving situations of the driver. The display apparatus needs to be limited or controlled in a viewing angle according to a user's needs for privacy and information protection.

### SUMMARY OF THE INVENTION

It is an object to provide a display apparatus with improved aesthetic feeling.

It is a further object to provide a display apparatus in which it is possible to suppress or prevent stabbing and scratch defects of a display panel, in particular due to a deposition mask.

It is an object to provide a display apparatus with improved reliability by suppressing or preventing defects of a display panel.

Objects of the specification are not limited to the above-described objects, and other technical objects may be inferred from the following embodiments.

The one or more objects are solved by the features of the independent claims. Preferred embodiments are given in the dependent claims.

According to an embodiment of the specification, there is provided a display apparatus including a substrate having a notch and including a display area including a plurality of pixels and a non-display area around or adjacent to the display area, a plurality of transistors disposed on the substrate, a display panel including a light-emitting part disposed on the plurality of transistors and including an anode electrode, a cathode electrode, and a light-emitting layer between the anode electrode and the cathode electrode, and a microlens disposed on light-emitting areas of the sub-pixels, wherein a pad part and a link part are disposed in the non-display area, and a plurality of data lines of which some are formed on different layers with an insulating layer interposed therebetween are alternately disposed in the link part.

In the following on or more optional features are provided which might be combined with the general aspect alone or in combination.

In one more embodiments, a metal layer may be disposed above the plurality of data lines.

In one more embodiments, the metal layer may be implemented in the form of a whole metal in an entirety of the link part.

In one more embodiments, the metal layer may be implemented in form of a plurality of islands in the link part.

In one more embodiments, the display apparatus may further comprise a spacer overlapping the metal layer.

In one more embodiments, the spacer may be formed to correspond to the metal layer in a bar type or a form of a plurality of islands.

In one more embodiments, the display apparatus may further comprise a storage electrode including a first electrode formed on the same layer as the gate electrode of the transistor and a second electrode corresponding to the first electrode.

In one more embodiments, the plurality of data lines may include a first data line, and a second data line formed of a different material from the first data line.

In one more embodiments, the first data line may be formed on the same layer as the gate electrode of the transistor.

In one more embodiments, the second data line may be formed on the same layer as the second electrode of the storage electrode.

In one more embodiments, at least one printed circuit film may be attached to the pad part.

In one more embodiments, the display apparatus may further comprise a voltage line and a gate control line that are electrically connected to the pad part.

In one more embodiments, the voltage line may intersect the gate control line or the plurality of data lines.

In one more embodiments, the substrate may further include a dam and a crack prevention part.

In one more embodiments, the pad part and the link part may be disposed between the dam and the crack prevention part.

In one more embodiments, the dam may overlap the voltage line and surrounds the display area.

In one more embodiments, the crack prevention part may be formed by recessing at least one insulating layer at an outermost edge of the non-display area.

In one more embodiments, a center of the microlens and a center of the light-emitting area may be misaligned.

In one more embodiments, the anode electrode may be tilted toward the microlens.

In one more embodiments, the plurality of sub-pixels may include a first pixel group in which a center of the microlens may be misaligned to the other side in a first direction compared to a center of the light-emitting area.

In one more embodiments, the plurality of sub-pixels may include a second pixel group in which the center of the microlens may be misaligned to one side in the first direction compared to the center of the light-emitting area.

In one more embodiments, the non-display area may further include a gate driving unit between the voltage line and the display area.

In one more embodiments, the display apparatus may further comprise a pixel gate driving unit located in the display area.

In one more embodiments, the pad part and the pixel gate driving unit may be electrically connected through the gate control line.

In one more embodiments, the display panel may include a first long edge, a second long edge, and a first short edge and a second short edge that connect the first long edge to the second long edge.

In one more embodiments, the second long edge may be formed to be longer than the first long edge.

Other features and advantages of the specification in addition to the above technical objects of the specification are described below or will be able to be clearly understood by those skilled in the art to which the specification pertains based on such a technology and descriptions.

According to the embodiments of the specification, it is possible to provide the display apparatus with improved aesthetic feeling.

According to the embodiments of the specification, it is possible to suppress or prevent stabbing and scratch defects of the display panel.

According to the embodiments of the specification, it is possible to suppress or prevent stabbing and scratch defects of the display panel due to the deposition mask.

According to the embodiments of the specification, it is possible to improve reliability by suppressing or preventing defects of the display panel.

According to the embodiments of the specification, it is possible to suppress or prevent stabbing or scratch defects, etc. during the process of the display panel, thereby preventing defects of the display apparatus, increasing the life thereof, and reducing production energy.

However, effects obtainable from the specification are not limited to the above-described effects, and other effects that are not mentioned will be able to be clearly understood by those skilled in the art to which the specification pertains based on the following description.

### BRIEF DESCRIPTION OF THE DRAWINGS

FIG. 1 is a plan view of a display apparatus according to one embodiment.
FIG. 2 is an enlarged view of area Q1 in FIG. 1.
FIG. 3 is a view illustrating only a display panel of FIG. 2.
FIG. 4 is a plan view illustrating a pixel arrangement of a display panel of one embodiment.
FIG. 5 is a cross-sectional view along line V-V' in FIG. 4.
FIG. 6 is a cross-sectional view of a touch part of FIG. 5 taken at a different angle.
FIG. 7 is a cross-sectional view along line A-A' in FIG. 1.
FIG. 8 is a cross-sectional view along line B-B' in FIG. 3.
FIG. 9 is a cross-sectional view along line C-C' in FIG. 3.
FIG. 10 is a cross-sectional view along line D-D' in FIG. 3.
FIG. 11 is a plan view of a notch non-display area of a second non-display area.
FIG. 12 is a cross-sectional view along line E-E' in FIG. 11.
FIG. 13 is a plan view of a display apparatus according to another embodiment.

### DETAILED DESCRIPTION OF THE INVENTION

Hereinafter, embodiments will be described with reference to the accompanying drawings. In the specification, when a first component (or an area, a layer, a portion, or the like) is described as "on," "adhere," "connected," or "coupled" to a second component, it means that the first component may be directly adhere/connected/coupled to the second component or a third component may be disposed therebetween.

The same reference numerals indicate the same components. In addition, in the drawings, thicknesses, proportions, and dimensions of components are exaggerated for effective description of technical contents. The term "and/or" includes all one or more combinations that may be defined by the associated configurations.

Terms such as first and second may be used to describe various components, but the components are not limited by the terms. The terms are used only for the purpose of distinguishing one component from another. For example, a first component may be referred to as a second component, and similarly, the second component may also be referred to as the first component without departing from the scopes of the embodiments. The singular includes the plural unless the context clearly dictates otherwise.

Terms such as "under," " at a lower side," "above," and "at an upper side" are used to describe the relationship between the components illustrated in the drawings. The terms are relative concepts and are described with respect to directions marked in the drawings.

It should be understood that term such as "includes" or "has" is intended to specify the presence of features, numbers, steps, operations, components, parts, or a combination thereof described in the specification and does not preclude the presence or addition possibility of one or more other features, numbers, steps, operations, components, parts, or combinations thereof in advance.

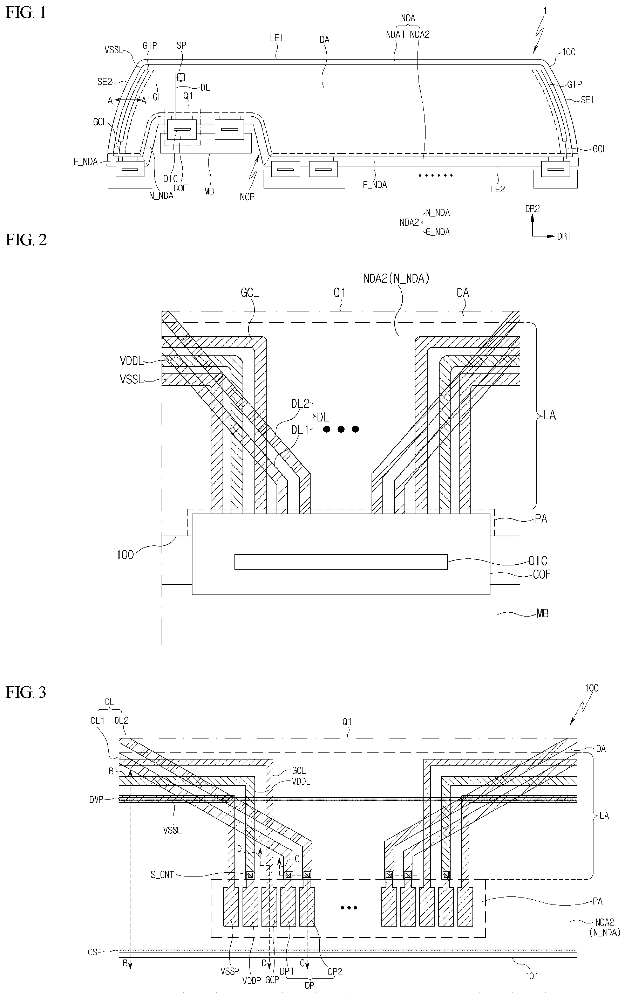

FIG. 1 is a plan view of a display apparatus of one embodiment. FIG. 2 is an enlarged view of area Q1 in FIG. 1. FIG. 3 is a view illustrating only a display panel of FIG. 2.

FIG. 3 is a view of FIG. 2 from which a flexible film COF, a main board MB, and a drive IC DIC are omitted except for the display panel 100. In FIG. 3, for convenience of description, ratios between components are adjusted.

Referring to FIGS. 1 to 3, a display apparatus 1 may be an apparatus including both a display function for displaying a video and a touch sensing function for sensing touch of a user, but is not limited thereto. For example, the display apparatus 1 may include only one of the display function for displaying a video and the touch sensing function for sensing touch of a user.

The display apparatus 1 may be an electroluminescent display apparatus or a micro light emitting diode display apparatus that includes a touch sensor. The electroluminescent display apparatus including the touch sensor may be an organic light emitting diode (OLED) display apparatus, a quantum-dot light emitting diode display apparatus, or an inorganic light emitting diode display apparatus.

The display apparatus 1 of the embodiment may be a vehicle display apparatus, but is not limited thereto. For example, the description of the display apparatus 1 may be applied without limitation to the type of the apparatus as long as a display apparatus is an apparatus including a display function.

When the display apparatus 1 of the embodiment is a vehicle display apparatus, the display apparatus 1 may include a function of manipulating at least some of various functions of a vehicle, a function of displaying various pieces of information about the vehicle, and the like.

When the display apparatus 1 of the embodiment is a vehicle display apparatus, the display apparatus 1 may be disposed on a dashboard of a vehicle. The display apparatus 1 may be disposed across a driver's seat and a front passenger's seat that are disposed at front seats of a vehicle, but is not limited thereto. Both a driver in the driver's seat and a passenger in the front passenger's seat can use the display apparatus 1.

The display apparatus 1 may include a display panel 100. The display panel 100 may include the display area DA and the non-display area NDA.

The display area DA may be an area in which light is emitted to the outside to display a screen. The display area DA may further include a function of sensing touch of a user. In this case, the display area DA may correspond to a touch sensing area, but is not limited thereto. So the touch area might be larger than the display area DA or might be smaller or only a part of display apparatus might have a display area and/or a touch sensing area.

The display area DA may correspond to the shape of the display panel 100, but is not limited thereto.

A plurality of sub-pixels SP (or pixels) may be disposed in the display area DA. The plurality of sub-pixels SP (or the pixels) may be repeatedly disposed in a first direction DR1 and a second direction DR2.

The non-display area NDA may be an area in which light is not emitted to the outside so as not to display a screen. The non-display area NDA may be located adjacent and/or around the display area DA. The non-display area NDA may fully or at least partly surround the display area DA, but the embodiments of the specification are not limited thereto. A bezel area of the display apparatus 1 may be defined by the non-display area NDA, but the embodiments of the specification are not limited thereto.

The display panel 100 may be a rigid display panel, but is not limited thereto. The display panel 100 may be a flexible display panel of which shape may be deformed, such as a foldable, bendable, rollable, or stretchable display panel.

The display panel 100 may include a first long edge LE1, a second long edge LE2, a first short edge SE1, and a second short edge SE2 that form an edge of the display panel 100.

The first long edge LE1 and the second long edge LE2 may extend in a first direction DR1, and the first short edge SE1 and the second short edge SE2 may extend in a direction between the first direction DR1 and a second direction DR2. The first long edge LE1 and the second long edge LE2 may have both ends connected through the first short edge SE1 and the second short edge SE2.

The first long edge LE1 may be disposed at one side of the second long edge LE2 in the second direction DR2. The first long edge LE1 and the second long edge LE2 may extend in parallel, but are not limited thereto. AS shown in Fig. 1 the edges of the substrate need not to be right angled to each other.

A length of the first long edge LE1 may be shorter than a length of the second long edge LE2. For example, since the length of the second long edge LE2 is formed to be longer than the length of the first long edge LE1, the first short edge SE1 and the second short edge SE2 that connect both ends of the first long edge LE1 to both ends the second long edge LE2 may extend in a direction intersecting each other, but are not limited thereto. That means the first short edge SE1 and the second short edge SE2 might not be parallel to each other.

The first direction DR1 and the second direction DR2 may be directions intersecting each other. The first direction DR1 and the second direction DR2 may be orthogonal, but are not limited thereto. The first direction DR1 and the second direction DR2 are provided to clarify the description of the disclosure, the first direction DR1 and the second direction DR2 are relative, and the embodiments of the specification are not limited thereto.

In a plan view, the first long edge LE1 may be disposed above the display area DA, and the second long edge LE2 may be disposed below the display area DA.

In a plan view, the first short edge SE1 may be disposed at the right side of the display area DA, and the second short edge SE2 may be disposed at the left side of the display area DA.

The display panel 100 may include a notch, preferably a curved notch NCP. The notch NCP may be formed at the second long edge LE2, but is not limited thereto. The notch is a recess in the substrate. For example, the second long edge LE2 may entirely extend in the first direction DR1, but may include the notch NCP that is curved toward the first long edge LE1.

Since the notch NCP is disposed, components, such as a handle of a driver's seat, may be disposed on the corresponding portion to maximize the display area DA capable of displaying the screen, thereby improving a user's convenience and improving aesthetic feeling.

The non-display area NDA may include a first non-display area NDA1 disposed along the first long edge LE1, the first short edge SE1, and the second short edge SE2, and a second non-display area NDA2 disposed along the second long edge LE2. The second non-display area NDA2 may be disposed along the second long edge LE2 including the curved notch NCP.

The first non-display area NDA1 may be disposed at one side and the other side of the display area DA in the first direction DR1 and disposed at one side of the display area DA in the second direction DR2.

The second non-display area NDA2 may include a notch non-display area N_NDA disposed around the notch NCP, and an extension non-display area E_NDA disposed around the notch non-display area N_NDA.

The extension non-display area E_NDA may extend from the notch non-display area N_NDA in the first direction DR1. The extension non-display area E_NDA may be disposed between the notch non-display area N_NDA and the first non-display area NDA1. The extension non-display area E_NDA may connect the notch non-display area N_NDA to the first non-display area NDA1.

The display apparatus 1 may further include a pad area (an implementation of "pad portion") PA, a link area LA, a gate driving unit GIP, a main board MB, a flexible film COF, a drive IC DIC, a gate line GL, a gate control line GCL, a data line DL, a low-potential voltage line VSSL, and a high-potential voltage line VDDL.

The pad area PA may overlap the flexible film COF. The pad area PA may be attached to the flexible film COF. For example, the display panel 100 and the flexible film COF may be attached through the pad area PA.

The pad area PA may be disposed in the non-display area NDA. The pad area PA may be disposed in the second non-display area NDA2. The pad area PA may be disposed in each of the notch non-display area N_NDA and the extension non-display area E_NDA.

The pad area PA may include a plurality of pads. The pad area PA may include at least one of a low-potential voltage pad VSSP, a high-potential voltage pad VDDP, a gate control pad GCP, a first data pad DP1, and a second data pad DP2. The low-potential voltage pad VSSP, the high-potential voltage pad VDDP, the gate control pad GCP, the first data pad DP1, and the second data pad DP2 may be disposed in the pad area PA.

FIG. 3 illustrates that the low-potential voltage pad VSSP, the high-potential voltage pad VDDP, the first data pad DP1, and the second data pad DP2 are sequentially disposed, but the embodiments of the specification are not limited thereto. For example, the first data pad DP1 and the second data pad DP2 may be disposed between the low-potential voltage pad VSSP and the high-potential voltage pad VDDP. The gate control pad GCP is illustrated as being disposed between the high-potential voltage pad VDDP and the data pad DP, but is not limited thereto, and arrangement locations of the low-potential voltage pad VSSP, the high-potential voltage pad VDDP, the gate control pad GCP, the first data pad DP1, and the second data pad DP2 in the pad area PA disposed in an area that is disposed at both ends of the flexible film COF disposed along the non-display area NDA and overlaps the flexible film COF may vary according to a design.

The plurality of pads VSSP, VDDP, DP, and GCP disposed in the pad area PA may be connected to the high-potential voltage line VDDL, the low-potential voltage line VSSL, the data line DL, and the gate control line GCL in the link area LA.

The gate driving unit GIP may be disposed in the non-display area NDA. The gate driving unit GIP may be disposed at at least one of one side and the other side of the display area DA in the first direction DR1, but is not limited thereto. In a plan view, the gate driving unit GIP may be disposed at the left side and the other side of the display area DA.

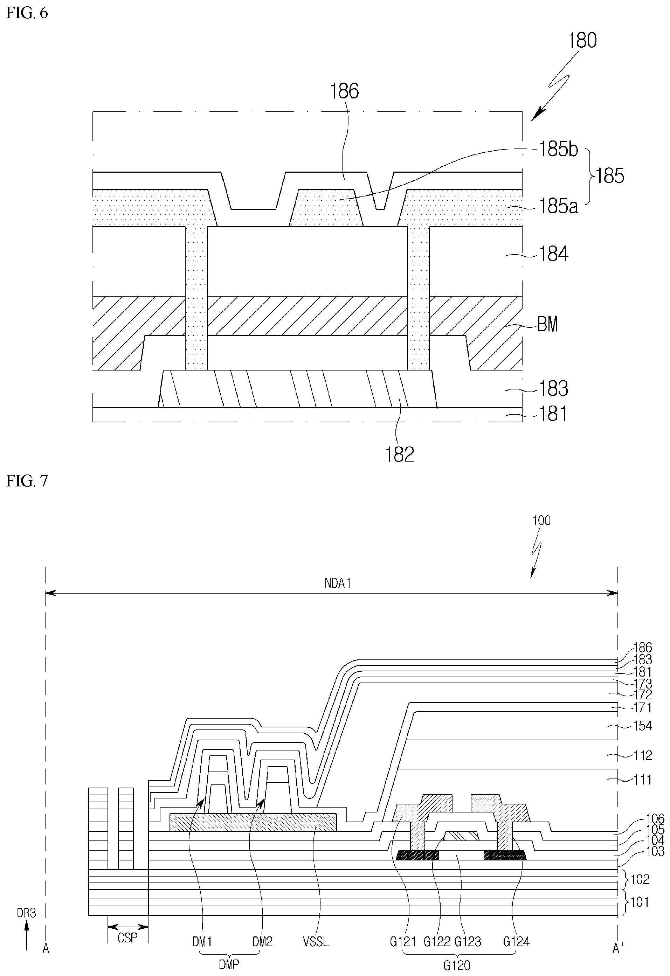

The gate driving unit GIP may include a plurality of transistors G120 (see FIG. 7). The transistors G120 (see FIG. 7) disposed in the gate driving unit GIP may be connected to a sub-pixel SP (or a pixel) through the gate line GL. The gate driving unit GIP may apply a gate signal to each sub-pixel SP (or each pixel) through the gate line GL.

The gate driving unit GIP may receive a gate control signal from the drive IC DIC through the gate control line GCL. The gate driving unit GIP may generate a scan signal and a light-emitting signal (or a light-emitting control signal) based on the gate control signal.

The gate driving unit GIP may include a scan driver and a light-emitting signal driver. The scan driver may generate a scan signal in a row-sequential manner and supply the scan signal to the scan lines in order to drive one or more scan lines connected to each sub-pixel SP (or each pixel) row. The light-emitting signal driver may generate a light-emitting signal in a row-sequential manner and supply the light-emitting signal to light-emitting signal lines in order to drive one or more light-emitting signal lines connected to each sub-pixel SP (or each pixel) row.

The main board MB may be connected to the display panel 100 through the flexible film COF. The main board MB may be electrically connected to the sub-pixel SP (or the pixel) of the display area DA through the flexible film COF. The main board MB may be electrically connected to the flexible film COF. The main board MB and the flexible film COF may be electrically connected through the plurality of pads VSSP, VDDP, and DP.

The main board MB may have various types of components for supplying various signals, such as a gate control signal, a driving signal, a data signal, etc., to the drive IC DIC. The main board MB may be a printed circuit board, but is not limited thereto.

The main board MB may be connected to the display panel 100 through the flexible film COF in the second non-display area NDA2. The main board MB may be provided as a plurality of main boards along the second non-display area NDA2, but is not limited thereto. The number of main boards MB may vary according to a design.

At least one of the main boards MB may be disposed around the notch NCP and connected to the display panel 100 through the flexible film COF in the notch non-display area N_NDA.

The flexible film COF may be connected to the display panel 100 and the main board MB. The flexible film COF may be attached to each of the display panel 100 and the main board MB and electrically connected to each of the display panel 100 and the main board MB. For example, the display panel 100 and the main board MB may be electrically connected through the flexible film COF. The flexible film COF may be provided as a plurality of flexible films, but is not limited thereto.

The flexible film COF may be attached to the display panel 100 in the second non-display area NDA2. The flexible film COF may be repeatedly disposed along the second non-display area NDA2. The flexible film COF may be attached to the display panel 100 across the notch non-display area N_NDA and the extension non-display area E_NDA.

A single main board MB may be electrically connected to the display panel 100 through at least one flexible film COF. For example, the main boards MB disposed at both ends among the plurality of main boards MB disposed along the second non-display area NDA2 may be electrically connected to the display panel 100 through one flexible film COF, and the remaining main boards MB may be electrically connected to the display panel 100 through two flexible films COF.

The flexible film COF may be electrically connected to the pad area PA. Accordingly, the flexible film COF may supply a gate control signal, driving signals, power voltages, data voltages, etc. to the plurality of sub-pixels SP (or the pixels) and the gate driving unit GIP that are disposed in the display area DA.

The flexible film COF may be a flexible insulating film including a plurality of conductive lines. The flexible film COF may include, for example, polycarbonate, polyethylene terephthalate, polyimide, polyamide, polyester, polyacrylate, polymethyl methacrylate, etc., but is not limited thereto.

The drive IC DIC may be mounted on the flexible film COF. The drive IC DIC may be disposed by a method of a chip on glass, a chip on film, a tape carrier package, etc. according to a mounting method. In the disclosure, the drive IC DIC is described as being mounted on the flexible film COF by the chip on film method, but is not limited thereto.

The drive IC DIC may drive the display apparatus 1. The drive IC DIC may process data signals for displaying an image, various driving signals for processing the data signals, etc. The drive IC DIC may include a gate driver IC, a data driver IC, etc.

Although not illustrated, the display apparatus 1 may further include a low dropout (LDO) regulator and a level shifter. The LDO regulator and the level shifter may be disposed on the main board MB, but are not limited thereto.

The drive IC DIC may be electrically connected to the LDO regulator and the level shifter and may transmit signals generated by the LDO regulator and the level shifter to the gate driving unit GIP.

The gate line GL may extend from the gate driving unit GIP and may be connected to the sub-pixel SP (or the pixel). The gate line GL may electrically connect the gate driving unit GIP to the sub-pixel SP (or the pixel). The gate line GL may apply a gate signal to each sub-pixel SP (or the pixel) from the gate driving unit GIP.

The gate control line GCL may be disposed in the non-display area NDA. The gate control line GCL may be disposed in the second non-display area NDA2, but is not limited thereto. The gate control line GCL may be disposed in an extension direction of the second non-display area NDA2.

The gate control line GCL may extend from the pad area PA to the gate driving unit GIP and may be electrically connected to the gate driving unit GIP. The gate control line GCL may be provided as a plurality of gate control lines, and the plurality of gate control lines GCL may supply at least two different signals.

The gate control line GCL may apply the gate control signal to the gate driving unit GIP. The gate control signal may be transmitted from the main board MB or the drive IC DIC. The gate control line GCL may electrically connect the gate driving unit GIP to the main board MB or the drive IC DIC.

The gate control line GCL may be electrically connected to the flexible film COF disposed at both ends among the plurality of flexible films COF connected to the display panel 100 along the second non-display area NDA2. The gate control line GCL may be disposed at an outermost edge among a plurality of lines connected to one flexible film COF, but is not limited thereto. The data line DL may extend from the pad area PA and may be connected to the sub-pixel SP (or the pixel) of the display area DA through the link area LA between the pad area PA and the display area DA. The data line DL may apply a data signal to each sub-pixel SP (or each pixel). The data signal may be applied from the main board MB or the drive IC DIC. The data line DL may electrically connect the sub-pixel SP (or the pixel) to the main board MB or the drive IC DIC.

The data line DL may include a first data line DL1 and a second data line DL2. The data line DL may be connected to the data pads DP1 and DP2. The first data line DL1 may be electrically connected in contact with the first data pad DP1 through a first data contact hole CNT1. The second data line DL2 may be electrically connected in contact with the second data pad DP2 through a second data contact hole CNT2.

The low-potential voltage line VSSL may be disposed in the non-display area NDA to surround the display area DA. The low-potential voltage line VSSL may be disposed in the non-display area NDA between the display area DA and the gate driving unit GIP . For example, the gate driving unit GIP may be disposed between the display area DA and the low-potential voltage line VSSL.

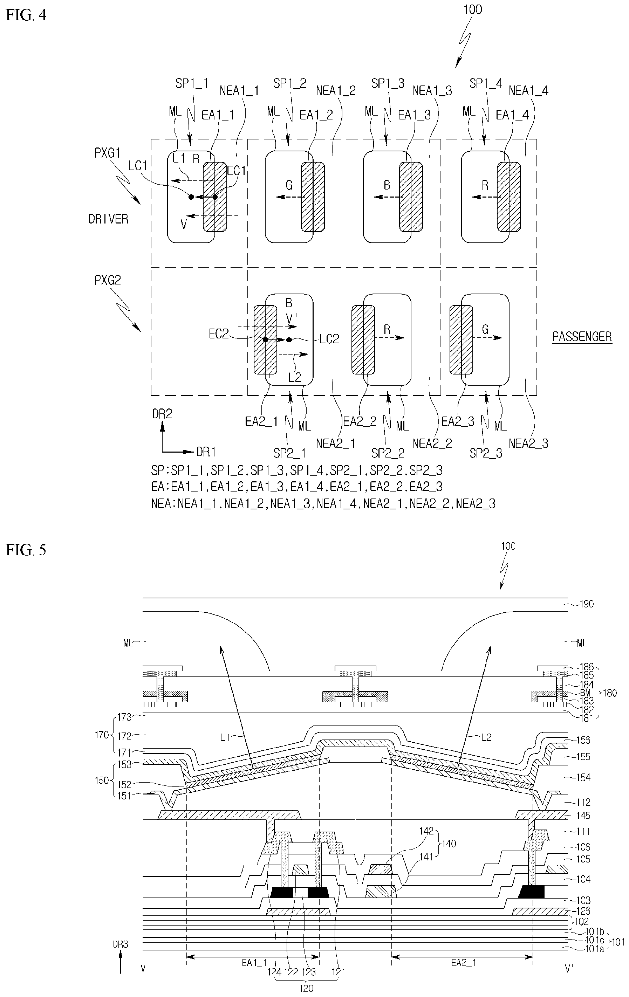

The low-potential voltage line VSSL may apply a low-potential voltage to the sub-pixel SP (or the pixel). The low-potential voltage line VSSL may be electrically connected to the cathode electrode 153 (see FIG. 5) of the sub-pixel SP (or the pixel) to apply a low-potential voltage.

The low-potential voltage line VSSL may be connected to the pad area PA. The low-potential voltage line VSSL may be physically connected to the low-potential voltage pad VSSP and electrically connected to the low-potential voltage pad VSSP. The low-potential voltage line VSSL and the low-potential voltage pad VSSP may be formed integrally, but are not limited thereto.

The high-potential voltage line VDDL may be disposed between the display area DA and the low-potential voltage line VSSL in the non-display area NDA. The high-potential voltage line VDDL may further include a high-potential connection electrode (not illustrated). The high-potential connection electrode (not illustrated) may be disposed on a different layer from the high-potential voltage line VDDL. For example, the high-potential connection electrode (not illustrated) may be disposed between a second insulating layer 104 and a third insulating layer 105. The high-potential connection electrode (not illustrated) may electrically connect the high-potential voltage line VDDL to the anode electrode 151 (see FIG. 5) across the lines disposed on the same layer as the high-potential voltage line VDDL. The high-potential connection electrode may be electrically connected to the anode electrode 151 (see FIG. 5) across the lines disposed on the same layer as the high-potential voltage line VDDL.

The high-potential voltage line VDDL may apply a high-potential voltage to the sub-pixel SP (or the pixel). The high-potential voltage line VDDL may be electrically connected to the anode electrode 151 (see FIG. 5) of the sub-pixel SP (or the pixel) to apply a high-potential voltage.

The high-potential voltage line VDDL may be connected to the pad area PA. The high-potential voltage line VDDL may be physically connected to the high-potential voltage pad VDDP and electrically connected to the high-potential voltage pad VDDP. The high-potential voltage line VDDL may come into contact with the high-potential voltage pad VDDP by a contact hole S_CNT.

However, the embodiments of the specification are not limited thereto, and the high-potential voltage line VDDL may be disposed on the same layer as the high-potential voltage pad VDDP and formed integrally with the high-potential voltage pad VDDP. For example, the high-potential voltage line VDDL may be formed of the same material and the same conductive layer as the high-potential voltage pad VDDP, and the high-potential voltage line VDDL and the high-potential voltage pad VDDP are formed together by the same mask process.

Even in this case, the high-potential connection electrode (not illustrated) disposed on a different layer from the high-potential voltage pad VDDP may be further included. The high-potential connection electrode (not illustrated) may electrically connect the high-potential voltage line VDDL to the anode electrode 151 (see FIG. 5) across the lines disposed on the same layer as the high-potential voltage line VDDL.

The display apparatus 1 may further include a dam part DMP. The dam part DMP may be disposed in the non-display area NDA. The dam part DMP may be disposed to surround the display area DA, but is not limited thereto. At least a part of the dam part DMP may be disposed to overlap the low-potential voltage line VSSL. The dam part DMP may be disposed between the display area DA and the pad area PA in the second non-display area NDA2.

The display apparatus 1 may further include a crack prevention pattern CSP. The crack prevention pattern CSP may be disposed at an outermost edge of the non-display area NDA. The crack prevention pattern CSP may be formed using one of the inorganic films disposed above the substrate 101.

The pad area PA and the link area LA may be disposed between the dam part DMP and the crack prevention pattern CSP. At least a part of the dam part DMP may be disposed to overlap the link area LA, but the embodiments of the specification are not limited thereto.

The high-potential voltage line VDDL, the low-potential voltage line VSSL, the data line DL, and the gate control line GCL that are connected to the plurality of pads VSSP, VDDP, DP, and GCP may be disposed in the link area LA. The high-potential voltage line VDDL, the low-potential voltage line VSSL, the data line DL, and the gate control line GCL may be disposed on different layers in the link area LA, and at least parts thereof may overlap one another. For example, the high-potential voltage line VDDL or the low-potential voltage line VSSL may be disposed to intersect the data line DL or the gate control line GCL.

FIG. 4 is a plan view illustrating a pixel arrangement of a display panel of one embodiment. The plan view of FIG. 4 is an enlarged view illustrating a part of the display area DA in which the pixels PX are disposed.

Referring to FIG. 4, the display panel 100 may include a first pixel group PXG1 and a second pixel group PXG2.

Each of the first pixel group PXG1 and the second pixel group PXG2 may be disposed repeatedly in the first direction DR1. The first pixel group PXG1 and the second pixel group PXG2 may be disposed alternately and repeatedly in the second direction DR2.

The sub-pixel SP may include a 1_1 sub-pixel SP1_1, a 1_2 sub-pixel SP1_2, a 1_3 sub-pixel SP1_3, a 1_4 sub-pixel SP1_4, a 2_1 sub-pixel SP2_1, a 2_2 sub-pixel SP2_2, and a 2_3 sub-pixel SP2_3.

The first pixel group PXG1 may include the 1_1 sub-pixel SP1_1, the 2_2 sub-pixel SP1_2, the 1_3 sub-pixel SP1_3, and the 1_4 sub-pixel SP1_4. The 1_1 sub-pixel SP1_1, the 1_2 sub-pixel SP1_2, the 1_3 sub-pixel SP1_3, and the 1_4 sub-pixel SP1_4 may be disposed in a row in the first direction.

The 1_1 sub-pixel SP1_1 may emit red (R) light, the 1_2 sub-pixel SP1_2 may emit green (G) light, the 1_3 sub-pixel SP1_3 may emit blue (B) light, and the 1_4 sub-pixel SP1_4 may emit red (R) light.

The 1_1 sub-pixel SP1_1, the 1_2 sub-pixel SP1_2, the 1_3 sub-pixel SP1_3, and the 1_4 sub-pixel SP1_4 may include light-emitting areas EA1_1, EA1_2, EA1_3, and EA1_4, and non-light-emitting areas NEA1_1, NEA1_2, NEA1_3, and NEA1_4 disposed around the light-emitting areas EA1_1, EA1_2, EA1_3, and EA1_4, respectively.

The 1_1 sub-pixel SP1_1 may include a 1_1 light-emitting area EA1_1, and a 1_1 non-light-emitting area NEA1_1 disposed around the 1_1 light-emitting area EA1_1.

The 1_2 sub-pixel SP1_2 may include a 1_2 light-emitting area EA1_2, and a 1_2 non-light-emitting area NEA1_2 disposed around the 1_2 light-emitting area EA1_2.

The 1_3 sub-pixel SP1_3 may include a 1_3 light-emitting area EA1_3, and a 1_3 non-light-emitting area NEA1_3 disposed around the 1_3 light-emitting area EA1_3.

The 1_4 sub-pixel SP1_4 may include a 1_4 light-emitting area EA1_4 and a 1_4 non-light-emitting area NEA1_4 disposed around the 1_4 light-emitting area EA1_4.

The second pixel group PXG2 may include the 2_1 sub-pixel SP2_1, the 2_2 sub-pixel SP2_2, and the 2_3 sub-pixel SP2_3. The 2_1 sub-pixel SP2_1, the 2_2 sub-pixel SP2_2, and the 2_3 sub-pixel SP2_3 may be disposed in a row in the second direction.

The 2_1 sub-pixel SP2_1 may emit blue (B) light, the 2_2 sub-pixel SP2_2 may emit red (R) light, and the 2_3 sub-pixel SP2_3 may emit green (G) light.

The 2-1 sub-pixel SP2_1, the 2_2 sub-pixel SP2_2, and the 2_3 sub-pixel SP2_3 may include light-emitting areas EA2_1, EA2_2, and EA2_3, and non-light-emitting areas NEA2_1, NEA2_2, and NEA2_3 disposed around the light-emitting areas EA2_1, EA2_2, and EA2_3.

The 2_1 sub-pixel SP2_1 may include a 2_1 light-emitting area EA2_1, and a 2_1 non-light-emitting area NEA2_1 disposed around the 2_1 light-emitting area EA2_1.

The 2_2 sub-pixel SP2_2 may include a 2_2 light-emitting area EA2_2, and a 2_2 non-light-emitting area NEA2_2 disposed around the 2_2 light-emitting area EA2_2.

The 2_3 sub-pixel SP2_3 may include a 2_3 light-emitting area EA2_3, and a 2_3 non-light-emitting area NEA2_3 disposed around the 2_3 light-emitting area EA2_3.

In a plan view, no sub-pixel may be disposed below (at the other side in the second direction DR2 of) the 1_1 sub-pixel SP1_1.

In a plan view, the 2_1 sub-pixel SP2_1 may be disposed below (at the other side in the second direction DR2 of) the 1_2 sub-pixel SP1_2.

In a plan view, the 2_2 sub-pixel SP2_2 may be disposed below (at the other side in the second direction DR2 of) the 1_3 sub-pixel SP1_3.

In a plan view, the 2_3 sub-pixel SP2_3 may be disposed below (at the other side in the second direction DR2) the 1_4 sub-pixel SP1_4.

The sub-pixel SP (see FIG. 1) illustrated in FIG. 1 may refer to one of the 1_1 sub-pixel SP1_1, the 1_2 sub-pixel SP1_2, the 1_3 sub-pixel SP1_3, the 1_4 sub-pixel SP1_4, the 2_1 sub-pixel SP2_1, the 2_2 sub-pixel SP2_2, and the 2_3 sub-pixel SP2_3.

A microlens ML may be disposed on the 1_1 sub-pixel SP1_1, the 1_2 sub-pixel SP1_2, the 1_3 sub-pixel SP1_3, the 1_4 sub-pixel SP1_4, the 2_1 sub-pixel SP2_1, the 2_2 sub-pixel SP2_2, and the 2_3 sub-pixel SP2_3. The microlens ML may be disposed in each sub-pixel SP (SP1_1, SP1_2, SP1_3, SP1_4, SP2_1, SP2_2, or SP2_3).

One microlens ML is illustrated as being disposed in each sub-pixel SP, but the embodiments of the specification are not limited thereto. For example, according to a design of each sub-pixel SP, the microlens ML disposed in each sub-pixel SP may be provided as two or more microlenses. When an opening (the light-emitting areas EA) formed in one sub-pixel SP is provided as a plurality of openings, the microlens ML may be disposed in each opening, or a plurality of microlenses ML may be disposed in one opening.

Each sub-pixel SP (SP1_1, SP1_2, SP1_3, SP1_4, SP2_1, SP2_2, or SP2_3) may include the light-emitting area EA (EA1_1, EA1_2, EA1_3, EA1_4, EA2_1, EA2_2, or EA2_3) and the non-light-emitting area NEA (NEA1_1, NEA1_2, NEA1_3, NEA1_4, NEA2_1, NEA2_2, or NEA2_3) disposed around the light-emitting area EA.

The microlens ML and the light-emitting area EA corresponding thereto may be misaligned. Specifically, a center of the microlens ML and a center of the light-emitting area EA may be misaligned.

A center EC1 of the 1_1 light-emitting area EA1_1 of the 1_1 sub-pixel SP1_1 and a center LC1 of the microlens ML disposed on the 1_1 sub-pixel SP1_1 may be misaligned. In a plan view, the center LC1 of the microlens ML may be misaligned from the center EC1 of the 1_1 light-emitting area EA1_1 to the other side (left side in a plan view) in the first direction DR1.

The description of the misalignment of the 1_1 sub-pixel SP1_1 may be applied to the remaining sub-pixels SP1_2, SP1_3, and SP1_4 of the first pixel group PXG1 in the substantially the same manner. However, in each of the sub-pixels SP1_1, SP1_2, SP1_3, and SP1_4 of the first pixel group PXG1, the degree of misalignment between the microlens ML and the light-emitting area EA may be different.

However, the embodiments of the specification are not limited thereto, and a direction in which the center LC1 of the microlens ML and the center EC1 of the 1_1 light-emitting area EA1_1 are misaligned may vary according to a design.

A center EC2 of the 2_1 light-emitting area EA2_1 of the 2_1 sub-pixel SP2_1 and a center LC2 of the microlens ML disposed on the 2_1 sub-pixel SP2_1 may be misaligned. In a plan view, the center LC2 of the microlens ML may be misaligned from the center EC2 of the 2_1 light-emitting area EA2_1 to one side (right side in a plan view) in the first direction DR1.

The description of the misalignment of the 2_1 sub-pixel SP2_1 may be applied to the remaining sub-pixels SP2_2 and SP2_3 of the second pixel group PXG2 in the substantially the same manner. However, in each of the sub-pixels SP2_1, SP2_2, and SP2_3 of the second pixel group PXG2, the degree of misalignment between the microlens ML and the light-emitting area EA may be different.

However, the embodiments of the specification are not limited thereto, and a direction in which the center LC2 of the microlens ML and the center EC2 of the 2_1 light-emitting area EA2_1 are misaligned may vary according to a design.

Hereinafter, a cross-sectional structure of the display area DA of the display panel 100 including the sub-pixel SP (SP1_1, SP1_2, SP1_3, SP1_4, SP2_1, SP2_2, and SP2_3) will be described with reference to FIG. 5.

FIG. 5 is a cross-sectional view along line V-V' in FIG. 4. FIG. 6 is a cross-sectional view of a touch part of FIG. 5 taken at a different angle.

Referring to FIGS. 4 to 6, the display panel 100 may include the substrate 101, the thin film transistor 120, the storage electrode 140, the light-emitting part 150, the encapsulation part 170, the touch part 180, etc. However, the embodiments of the specification are not limited thereto.

The substrate 101 may provide a space in which various components may be disposed thereon. The substrate 101 may correspond to the flat surface shape of the display panel 100 of FIG. 1. For example, the substrate 101 may include the notch NCP. The substrate 101 may include the display area DA and the non-display area NDA of the display panel 100 in substantially the same manner.

The substrate 101 may include one or more plastic materials, but is not limited thereto, and may include a glass material.

The substrate 101 may be a multi-substrate including a plurality of substrates such as a first substrate 101a, a second substrate 101b, and a third substrate 101c each including a plastic material, such as polyimide, but the embodiments of the specification are not limited thereto. For example, the substrate 101 may be a single substrate formed of a single layer.

The substrate 101 may include a rigid substrate. However, the embodiments of the present specification are not limited thereto, and the substrate 101 may include a flexible substrate.

The buffer layer 102 may be disposed on the substrate 101. The buffer layer 102 can minimize or delay the diffusion of moisture or oxygen penetrating the substrate 101. The buffer layer 102 may be formed by alternately stacking silicon nitride (SiNₓ) and silicon oxide (SiOₓ) at least once, but the embodiments of the specification are not limited thereto.

The specification describes that the buffer layer 102 is formed as multiple layers formed of three layers, but the number of layers forming the buffer layer 102 is not limited thereto, and the buffer layer 102 may be formed as a single layer.

A first light-shielding layer 126 may be disposed on the buffer layer 102. The first light-shielding layer 126 can prevent light from transmitting a semiconductor layer 123 of the thin film transistor 120. For example, the first semiconductor layer 123 may be disposed to overlap the first light-shielding layer 126. The first light-shielding layer 126 may be formed of a single layer or multiple layers formed of one of molybdenum (Mo), aluminum (Al), chromium (Cr), nickel (Ni), neodymium (Nd), and copper (Cu) or an alloy thereof, but the embodiments of the specification are not limited thereto.

A first insulating layer 103 may be disposed on the first light-shielding layer 126. The first insulating layer 103 can prevent a short circuit between a component of the first thin film transistor 120 and the first light-shielding layer 126. The first insulating layer 103 may be formed of the same material as the buffer layer 102, but the embodiments of the specification are not limited thereto. For example, the first insulating layer 103 may be formed of an inorganic material, such as silicon nitride (SiNₓ) or silicon oxide (SiOₓ), but the embodiments of the specification are not limited thereto.

The thin film transistor 120 may be disposed on the first insulating layer 103. The thin film transistor 120 may include a source electrode 121, a gate electrode 122, a semiconductor layer 123, and a drain electrode 124.

The semiconductor layer 123 may be disposed on the first insulating layer 103. The semiconductor layer 123 may include a metal oxide semiconductor, such as indium-gallium-zinc oxide (IGZO), and a silicon-based semiconductor material, such as amorphous silicon or polycrystalline silicon, but the embodiments of the specification are not limited thereto. The semiconductor layer 123 may include a source area, a drain area, and a channel area between the source area and the drain area.

Since the polycrystalline semiconductor layer has higher mobility than the amorphous semiconductor layer and the oxide semiconductor layer, power consumption can be less, and reliability can be excellent. Accordingly, a driving transistor may be formed of a polycrystalline semiconductor layer, but the embodiments of the specification are not limited thereto.

The second insulating layer 104 may be disposed on the semiconductor layer 123. The second insulating layer 104 may be formed of the same material as the first insulating layer 103, but the embodiments of the specification are not limited thereto. The second insulating layer 104 can prevent a short circuit between the semiconductor layer 123 and another component of the thin film transistor 120.

The gate electrode 122 may be disposed on the second insulating layer 104. The gate electrode 122 may be disposed on the second insulating layer 104 to overlap the channel area of the semiconductor layer 123. The gate electrode 122 may be formed of a single layer or multiple layers made of molybdenum (Mo), copper (Cu), titanium (Ti), aluminum (Al), chromium (Cr), gold (Au), nickel (Ni), neodymium (Nd), or a compound thereof, but the embodiments of the specification are not limited thereto. The gate electrode 122 may be disposed along with the gate line, but the embodiments of the specification are not limited thereto.

The third insulating layer 105 may be disposed on the gate electrode 122. The third insulating layer 105 may be formed of the same material as the first insulating layer 103 or the second insulating layer 104, but the embodiments of the specification are not limited thereto.

The storage electrode 140 may be disposed to be spaced apart from the thin film transistor 120. The storage electrode 140 may include a first storage electrode 141 and a second storage electrode 142.

The first storage electrode 141 may be formed of the same material as the gate electrode 122 and formed on the same layer as the gate electrode 122, but the embodiments of the specification are not limited thereto.

The second storage electrode 142 may be disposed on the first storage electrode 141. The second storage electrode 142 may be disposed on the third insulating layer 105, and the third insulating layer 105 between the first storage electrode 141 and the second storage electrode 142 may be used as a dielectric to generate a capacitance. The first storage electrode 141 may be formed of the same material as the gate electrode 122 of the thin film transistor 120 on the same layer as the gate electrode 122 of the thin film transistor 120. The second storage electrode 142 may be formed of the same material as the first storage electrode 141, but the embodiments of the specification are not limited thereto, and the second storage electrode 142 may be formed of a different material from the first storage electrode 141.

A fourth insulating layer 106 may be disposed on the second storage electrode 142. The fourth insulating layer 106 may be formed of the same material as the first insulating layer 103, the second insulating layer 104, or the third insulating layer 105, but the embodiments of the specification are not limited thereto.

The source electrode 121 and the drain electrode 124 may be disposed on the fourth insulating layer 106.

The source electrode 121 and the drain electrode 124 may be electrically connected to the semiconductor layer 123 through contact holes. The source electrode 121 and the drain electrode 124 may be formed of a metallic material. For example, the source electrode 121 and the drain electrode 124 may be formed of a single layer or multiple layers made of one of molybdenum (Mo), aluminum (Al), chromium (Cr), gold (Au), titanium (Ti), nickel (Ni), neodymium (Nd), and copper (Cu) or an alloy thereof, but the embodiments of the specification are not limited thereto.

The source electrode 121 and the drain electrode 124 may be disposed along with the data line. For example, the data line may be formed of the same material as the source electrode 121 and the drain electrode 124 and formed on the same layer as the source electrode 121 and the drain electrode 124, but the embodiments of the specification are not limited thereto.

The thin film transistor 120 may be a driving transistor, and although not illustrated, the display panel 100 may further include a switching transistor, but the embodiments of the specification are not limited thereto.

A first protective layer 111 may be disposed on the source electrode 121 and the drain electrode 124.

The first protective layer 111 may planarize an upper portion of the thin film transistor 120 and protect the thin film transistor 120. The first protective layer 111 may be formed of an organic material. For example, the first protective layer 111 may be formed of an organic material containing an acrylic resin, an epoxy resin, a phenolic resin, a polyamide resin, or a polyimide resin, but the embodiments of the specification are not limited thereto.

A second protective layer 112 may be disposed on the first protective layer 111. The second protective layer 112 may be formed of the same material as the first protective layer 111, but the embodiments of the specification are not limited thereto.

A connection electrode 145 may be disposed between the first protective layer 111 and the second protective layer 112.

The connection electrode 145 may electrically connect the thin film transistor 120 to the light-emitting part 150. The connection electrode 145 may be formed of the same material as the source electrode 121 and the drain electrode 124, but the embodiments of the specification are not limited thereto.

The connection electrode 145 may come into contact with the drain electrode 124 through the contact hole formed in the first protective layer 111 and may be electrically connected to the drain electrode 124.

The connection electrode 145 may be formed of a single layer or multiple layers made of any one of molybdenum (Mo), aluminum (Al), chromium (Cr), gold (Au), titanium (Ti), nickel (Ni), neodymium (Nd), and copper (Cu) or an alloy thereof, but the embodiments of the specification are not limited thereto.

The light-emitting part 150 may be disposed on the second protective layer 112. The light-emitting part 150 may include an anode electrode 151, an organic layer 152, and a cathode electrode 153.

The anode electrode 151 may be disposed on the second protective layer 112. The anode electrode 151 may be electrically connected to the thin film transistor 120 through a contact hole formed in the first protective layer 111 and the second protective layer 112.

The anode electrode 151 may be a reflective electrode that reflects light, but the embodiments of the specification are not limited thereto. The anode electrode 151 may include a metallic material with high reflectivity, such as a stacking structure (Ti/Al/Ti) of aluminum (Al) and titanium (Ti), a stacking structure (ITO/Al/ITO) of aluminum (Al) and indium tin oxide (ITO), or an APC alloy and may be formed of a single layer or multiple layers, but the embodiments of the specification are not limited thereto.

For example, the cathode electrode 153 may include a material, such as indium tin oxide (ITO) or indium zinc oxide (IZO), but the embodiments of the specification are not limited thereto.

The organic layer 152 may be disposed on the anode electrode 151. The organic layer 152 may include one or more light-emitting structures (or light-emitting elements or elements) stacked on the anode electrode 151 in the order or reverse order of a hole transfer layer and an electron transfer layer. For example, the hole transfer layer may include a hole transporting layer, a hole injecting layer, an electron blocking layer, a p-type charge generation layer, etc., but the embodiments of the specification are not limited thereto. For example, the electron transfer layer may include an electron transporting layer, an electron injecting layer, a hole blocking layer, an n-type charge generation layer, etc., but the embodiments of the specification are not limited thereto.

The organic layer 152 may be an organic light-emitting layer, an inorganic light-emitting layer, a quantum dot light-emitting layer, a micro light-emitting diode, a micro mini light-emitting diode, etc., but the embodiments of the specification area not limited thereto. For example, the organic layer 152 of the display panel 100 of one embodiment of the specification may include an organic light-emitting layer. The organic layer 152 may include a red light-emitting layer, a green light-emitting layer, and a blue light-emitting layer, but the embodiments of the specification are not limited thereto. The organic layer 152 may be a white light-emitting layer, but the embodiments of the specification are not limited thereto.

The cathode electrode 153 may be disposed on the organic layer 152. The cathode electrode 153 may be a transparent electrode that transmits light, but the embodiments of the specification are not limited thereto. For example, the cathode electrode 153 may include a transparent conductive material, such as indium tin oxide (ITO) or indium zinc oxide (IZO), or a metal that transmits visible light or allows visible light to pass through, but the embodiments of the specification are not limited thereto.

The capping layer 156 may be further disposed on the cathode electrode 153. The capping layer 156 can reduce or minimize damage to the cathode electrode 153 of the light-emitting element EL and the organic layers 152 located below the cathode electrode 153 from an external light source. The capping layer 156 may be formed of an organic or inorganic film.

The capping layer 156 may be disposed using a material, such as LiF or the like, as an inorganic film and may further include an organic film, but the embodiments of the specification are not limited thereto. For example, the capping layer 156 may be formed of the stacking structure of an organic film and an inorganic film, and a thickness of the organic film may differ from a thickness of the inorganic film. In this case, the thickness of the organic film may be greater than the thickness of the inorganic film. As another example, the capping layer 156 may be formed of two or more layers by stacking materials having different refractive indexes. Accordingly, it is possible to increase the light efficiency of the display panel 100.

A bank 154 may be disposed to expose the anode electrode 151. The bank 154 may define the opening (or the light-emitting area EA) of the sub-pixel SP and may be disposed to cover an edge of the anode electrode 151. The organic layer 152 may be disposed in the opening of the sub-pixel SP. For example, the organic layer 152 may be disposed on the anode electrode 151 exposed by the bank 154.

The bank 154 may be formed of a material containing black pigment, or an organic material, such as a benzocyclobutene resin, a polyimide resin, an acrylic resin, a photosensitive polymer, etc., but the embodiments of the specification are not limited thereto. When the bank 154 is formed of a material containing black pigment or black dye, the bank 154 may be a black bank. When the bank 154 is formed of a material containing black pigment or black dye, it is possible to shield external light or light reflected from the outside, thereby further increasing the luminance of the display apparatus.

A spacer 155 may be further disposed on the bank 154. The spacer 155 may be formed of the same material as the bank 154, but the embodiments of the specification are not limited thereto. The spacer 155 can prevent sagging of a mask during a mask process, thereby suppressing or preventing stabbing and scratching defects, etc. of the display panel 100.

The encapsulation part 170 may be disposed on the bank 154 or the light-emitting part 150. The encapsulation part 170 may include one or more insulating layers. For example, the encapsulation part 170 may include a first inorganic encapsulation layer 171, an organic encapsulation layer 172 formed on the first inorganic encapsulation layer 171, and a second inorganic encapsulation layer 173 formed on the organic encapsulation layer 172. The encapsulation part 170 may include one or more inorganic layers and one or more organic layers. For example, the first inorganic encapsulation layer 171 and the second inorganic encapsulation layer 173 may include an inorganic material, and the organic encapsulation layer 172 may include an organic material, but the embodiments of the specification are not limited thereto.

Even when the first inorganic encapsulation layer 171 and the second inorganic encapsulation layer 173 may be disposed to extend to an end of the non-display area NDA, the organic encapsulation layer 172 may be ended inside the dam part DMP. For example, the organic encapsulation layer 172 may be disposed inside an area surrounded by the dam part DMP without extending beyond the dam part DMP.

The touch part 180 may be disposed on the encapsulation part 170. The touch part 180 may include a touch buffer layer 181, a first touch electrode 182, a first touch insulating layer 183, a black matrix BM, a second touch insulating layer 184, a second touch electrode 185, and a third touch insulating layer 186.

The touch buffer layer 181 may be disposed on the encapsulation part 170. For example, the touch buffer layer 181 may be disposed on the second inorganic encapsulation layer 173. The touch buffer layer 181 may be formed of the same material as the buffer layer 102, but the embodiments of the specification are not limited thereto.

The first touch electrode 182 may be disposed on the touch buffer layer 181.

The first touch insulating layer 183 may be disposed on the first touch electrode 182. The first touch insulating layer 183 may be formed of silicon oxide (SiOₓ), silicon nitride (SiNₓ), or multiple layers thereof, but the embodiments of the specification are not limited thereto.

The black matrix BM may be disposed on the first touch insulating layer 183. The black matrix BM may include materials capable of absorbing light. The black matrix BM may include a black pigment or dye, but is not limited thereto. The black matrix BM can prevent a light leakage defect, etc. that may occur between the sub-pixels SP.

The second touch insulating layer 184 may be disposed on the black matrix BM. The second touch insulating layer 184 may include an organic insulation material. For example, the second touch insulating layer 184 may be formed of photo acryl, benzocyclobutene (BCB), polyimide (PI), or polyamide (PA), but is not limited thereto.

The second touch electrode 185 may be disposed on the second touch insulation layer 184. The second touch electrode 185 may include a 1a touch electrode 185a extending in the first direction DR1 and a 1b touch electrode 185b extending in the second direction DR2 different from the first direction.

The first touch electrode 182 may be electrically connected to a 1a touch electrode 185a through a contact hole formed in the insulating layer 184. For example, the 1a touch electrode 185a and the first touch electrode 182 may extend in the first direction DR1.

The first touch electrode 182 and the second touch electrode 185 may include a metallic material. For example, the sensor electrode 185 and the bridge electrode 182 may be formed of titanium (Ti), nickel (Ni), aluminum (Al), or an alloy thereof and formed of a triple layer, such as titanium (Ti)/aluminum (Al)/titanium (Ti), but the embodiments of the specification are not limited thereto.

One of the first touch electrode 182 and the second touch electrode 185 may include a function of detecting touch, and the other may include a function of driving touch, but the embodiments of the specification are not limited thereto.

The third touch insulating layer 186 may be disposed on the second touch electrode 185. The third touch insulating layer 186 may be formed of the same material as the first touch insulating layer 183, but is not limited thereto.

The microlens ML may be disposed on the third touch insulating layer 186. The microlens ML may include a hemispherical or semi-cylindrical shape, but is not limited thereto. The shape of the microlens ML may vary according to the size, shape, etc. of the light-emitting area EA.

By arranging the microlens ML, it is possible to secure a wide viewing angle characteristic, increase luminance, and prevent light leakage by shielding leaked light, reflected light, etc.

The center of the microlens ML and the center of the light-emitting area EA corresponding thereto may be misaligned. However, since some components of the light-emitting part 150 may be tilted, light emitted from the light-emitting area EA may travel to the microlens ML.

A lens protective film 190 may be disposed on the microlens ML. The lens protective film 190 may include an organic insulation material, but is not limited thereto. The lens protective film 190 may protect the microlens ML by covering the microlens ML.

A refractive index of the lens protective film 190 may be smaller than a refractive index of the microlens ML. Accordingly, due to a difference in refractive indexes between the microlens ML and the lens protective film 190, light that has passed through the microlens ML can be prevented from being reflected toward the substrate 101.

In the area in which the light-emitting part 150 is disposed, a part of an upper surface of the second protective layer 112 may be formed to have inclination. The light-emitting part 150 may be disposed on the second protective layer 112 of which at least a part is inclined. Accordingly, at least a part of each of the anode electrode 151 and the organic layer 152 may be tilted. The at least a part of each of the anode electrode 151 and the organic layer 152 may be tilted toward the microlens ML.

Specifically, each of the anode electrode 151 and the organic layer 152 may be disposed on the second protective layer 112 of which at least a part is inclined. Each of the anode electrode 151 and the organic layer 152 may be disposed on the second protective layer 112 of which the entire area is inclined, but is not limited thereto.

A part of the second protective layer 112 may include an inclined surface. The embodiments of the specification are not limited thereto, but, for example, the inclined surface of the second protective layer 112 may be formed by a slit mask process.

The anode electrode 151 and the organic layer 152 that are disposed on the inclined second protective layer 112 may be disposed to be inclined (tilted) corresponding to the inclined second protective layer 112. Accordingly, a part of the cathode electrode 153 disposed on the organic layer 152 may be disposed to be inclined.

For example, the anode electrode 151 and the organic layer 152 may be disposed to be inclined in the thickness direction (the third direction DR3) of the display panel 100 in the 1_1 light-emitting area EA1_1, the 2_1 light-emitting area EA2_1, and surrounding areas thereof. For example, a direction in which the upper surface of the anode electrode 151 and the upper surface of the organic layer 152 face may be inclined in the thickness direction (the third direction DR3) of the display panel 100.

In the first light-emitting area EA1_1, the second light-emitting area EA2_1, and the surrounding areas thereof, the directions in which the anode electrode 151 and the organic layer 152 are inclined may be different.

In FIG. 5, the anode electrode 151 and the organic layer 152 around the 1_1 light-emitting area EA1_1 of the 1_1 sub-pixel SP1_1 and the 2_1 light-emitting area EA2_1 of the 2_1 sub-pixel SP2_1 have been described, but the descriptions thereof may be applied to all of the sub-pixels SP.

Accordingly, light emitted from each sub-pixel SP may be inclined in the thickness direction (the third direction DR3) of the display panel 100.

As the microlens ML and the light-emitting area EA are misaligned, even when light L1 and L2 emitted from the light-emitting part 150 travels while tilted with respect to the thickness direction (the third direction DR3), each light L1 or L2 may travel toward the microlens ML.

The sub-pixels SP1_1, SP1_2, SP1_3, and SP1_4 disposed in the first pixel group PXG1 may emit the light L1 to the left (the other side in the first direction DR1) in a plan view. The sub-pixels SP2_1, SP2_2, and SP2_3 disposed in the second pixel group PXG2 may emit the light L2 to the right (one side in the first direction DR1) in a plan view.

For example, the light L1 emitted from the sub-pixels SP1_1, SP1_2, SP1_3, and SP1_4 of the first pixel group PXG1 may travel while tilted to the other side in the first direction DR1 with respect to the thickness direction (the third direction DR3). The light L2 emitted from the sub-pixels SP2_1, SP2_2, and SP2_3 of the second pixel group PXG2 may travel while tilted to one side in the first direction DR1 with respect to the thickness direction (the third direction DR3).

The direction and degree of misalignment of the microlens ML and the light-emitting area EA may vary according to the traveling direction of the light emitted from the sub-pixels SP of each pixel group PXG1 or PXG2.

In a plan view, the sub-pixels SP1_1, SP1_2, SP1_3, and SP1_4 disposed in the first pixel group PXG1 and the sub-pixels SP2_1, SP2_2, and SP2_3 disposed in the second pixel group PXG2 may emit light in different directions, and thus a screen displayed to a driver DRIVER sitting in the driver's seat may be distinguished from a screen displayed to a passenger PASSENGER sitting in the passenger's seat so that each may be controlled separately, and different screens may be displayed to the driver DRIVER and the passenger PASSENGER.

Hereinafter, a cross-sectional structure of the non-display area NDA of the display apparatus 1 will be described. The same content as that described in the cross-sectional structure of the display area DA will be briefly described or omitted.

FIG. 7 is a cross-sectional view along line A-A' in FIG. 1. FIG. 7 illustrates the cross-sectional structure of the first non-display area NDA1.

Referring to FIGS. 1, 5, and 7, in the first non-display area NDA1, the display panel 100 may include the substrate 101, the buffer layer 102, the first insulating layer 103, the second insulating layer 104, the third insulating layer 105, the fourth insulating layer 106, the first protective layer 111, the second protective layer 112, the bank 154, the encapsulation part 170, the touch buffer layer 181, the first touch insulating layer 183, and the third touch insulating layer 186 that are sequentially disposed.

In the first non-display area NDA1, the display panel 100 may further include the gate control transistor G120, the low-potential voltage line VSSL, the dam part DMP, and the crack prevention pattern CSP.

The gate control transistor G120 may have substantially the same configuration as the thin film transistor 120 of the pixel SP and may be formed together by the same process as the thin film transistor 120 of the pixel SP, but is not limited thereto.

The gate control transistor G120 may include a control source electrode G121, a control gate electrode G122, a control semiconductor layer G123, and a control drain electrode G124.

The low-potential voltage line VSSL may be disposed on the fourth insulating layer 106 in the non-display area NDA. The low-potential voltage pad VSSL may be disposed on the same layer as the source electrode 121 and the drain electrode 124, may include the same material as the source electrode 121 and the drain electrode 124, and may be formed together using one mask by the same process as the source electrode 121 and the drain electrode 124, but is not limited thereto.

Although not illustrated, the low-potential voltage line VSSL may further include a separate low-potential voltage connection electrode to come into contact with the cathode electrode 153. The low-potential voltage connection electrode may be disposed on a different layer from the low-potential voltage line VSSL and may include a different material from the low-potential voltage line VSSL, but is not limited thereto. Through the low-potential voltage connection electrode, the low-potential voltage line VSSL may be electrically connected to the anode electrode 151 of the light-emitting part 150 disposed in the display area DA across other lines disposed on the same layer.

The dam part DMP may include a first dam DM1 and a second dam DM2. The first dam DM1 and the second dam DM2 may overlap the low-potential voltage line VSSL. The first dam DM1 may be disposed outside the second dam DM2, but is not limited thereto.

The first dam DM1 may be formed in a multilayered structure. Each layer of the first dam DM1 may include the same material as the second protective layer 112, the bank 154, and the spacer 155 and may be formed together using one mask by the same process as the second protective layer 112, the bank 154, and the spacer 155, but is not limited thereto.

The second dam DM2 may be formed in a multilayered structure. Each layer of the second dam DM2 may include the same material as the second protective layer 112 and the bank 154 and may be formed together using one mask by the same process as second protective layer 112 and the bank 154, but is not limited thereto.

The crack prevention pattern CSP may be disposed at an outermost edge of the non-display area NDA. Although not illustrated, the crack prevention pattern may be provided as a plurality of crack prevention pattern, but is not limited thereto. The crack prevention pattern CSP may be defined by recessing at least one of the inorganic films disposed on the substrate 101.

For example, the crack prevention pattern CSP may be defined by recessing the first insulating layer 103, the second insulating layer 104, the third insulating layer 105, the fourth insulating layer 106, the first inorganic encapsulation layer 171, the second inorganic encapsulation layer 173, the touch buffer layer 181, the first touch insulating layer 183, and the third touch insulating layer 186, but is not limited thereto. For example, at least one of the first protective layer 111, the second protective layer 112, and the bank 154 may be further disposed around the crack prevention pattern CSP. In this case, the crack prevention pattern CSP may be defined by further recessing at least one of the first protective layer 111, the second protective layer 112, and the bank 154 as well as the first insulating layer 103, the second insulating layer 104, the third insulating layer 105, the fourth insulating layer 106, the first inorganic encapsulation layer 171, the second inorganic encapsulation layer 173, the touch buffer layer 181, the first touch insulating layer 183, and the third touch insulating layer 186.

At least some of the inorganic films disposed on the substrate 101 may extend to the end of the non-display area NDA. For example, at least some of the inorganic films disposed on the substrate 101 may extend to an end of the substrate 101.

The buffer layer 102, the first insulating layer 103, the second insulating layer 104, the third insulating layer 105, the fourth insulating layer 106, the first inorganic encapsulation layer 171, the second inorganic encapsulation layer 173, the touch buffer layer 181, the first touch insulating layer 183, and the third touch insulating layer 186 may extend to an end of the first non-display area NDA1.

For example, in the first non-display area NDA1, the buffer layer 102, the first insulating layer 103, the second insulating layer 104, the third insulating layer 105, the fourth insulating layer 106, the first inorganic encapsulation layer 171, the second inorganic encapsulation layer 173, the touch buffer layer 181, the first touch insulating layer 183, and the third touch insulating layer 186 may extend to the end of the substrate 101.

In the first non-display area NDA1, the buffer layer 102, the first insulating layer 103, the second insulating layer 104, the third insulating layer 105, the fourth insulating layer 106, the first inorganic encapsulation layer 171, the second inorganic encapsulation layer 173, the touch buffer layer 181, the first touch insulating layer 183, and the third touch insulating layer 186 may substantially cover the entire area of the substrate 101.

Ends (or side surfaces) of the substrate 101, the buffer layer 102, the first insulating layer 103, the second insulating layer 104, the third insulating layer 105, the fourth insulating layer 106, the first inorganic encapsulation layer 171, the second inorganic encapsulation layer 173, the touch buffer layer 181, the first touch insulating layer 183, and the third touch insulating layer 186 may be aligned, but are not limited thereto.

However, the embodiments of the specification are not limited thereto, and in the first non-display area NDA1, at least one of the buffer layer 102, the first insulating layer 103, the second insulating layer 104, the third insulating layer 105, the fourth insulating layer 106, the first inorganic encapsulation layer 171, the second inorganic encapsulation layer 173, the touch buffer layer 181, the first touch insulating layer 183, and the third touch insulating layer 186 may not extend to the end of the substrate 101.

For example, in the first non-display area NDA1, the buffer layer 102, the first insulating layer 103, the second insulating layer 104, the third insulating layer 105, and the fourth insulating layer 106 may extend to the end of the substrate 101, the first inorganic encapsulation layer 171 and the second inorganic encapsulation layer 173 may extend only to the dam part DMP, and the touch buffer layer 181, the first touch insulating layer 183, and the third touch insulating layer 186 may extend until before the dam part DMP. For example, the buffer layer 102, the first insulating layer 103, the second insulating layer 104, the third insulating layer 105, and the fourth insulating layer 106 may be disposed between the dam part DMP and the crack prevention pattern CSP, and the first inorganic encapsulation layer 171, the second inorganic encapsulation layer 173, the touch buffer layer 181, the first touch insulating layer 183, and the third touch insulating layer 186 may not be disposed.

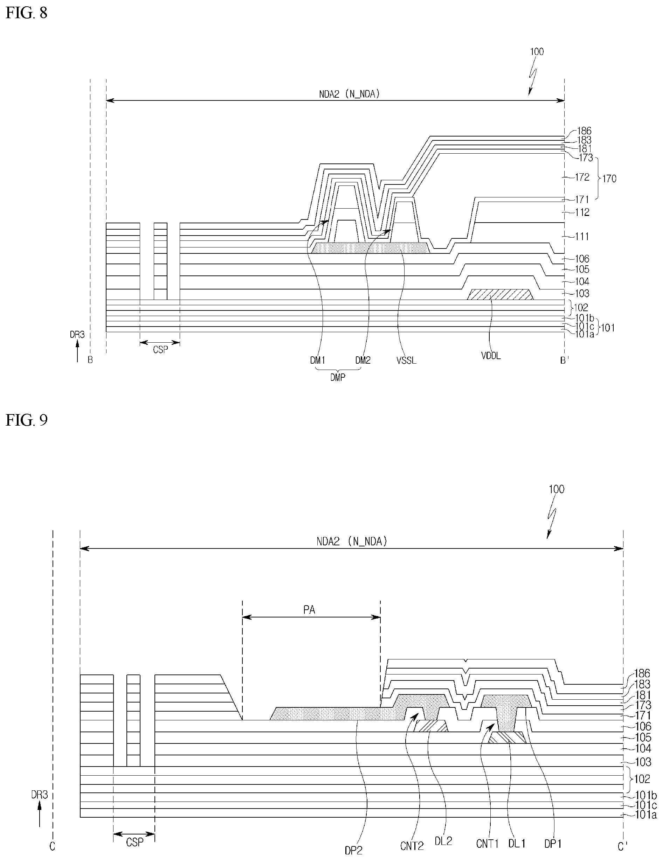

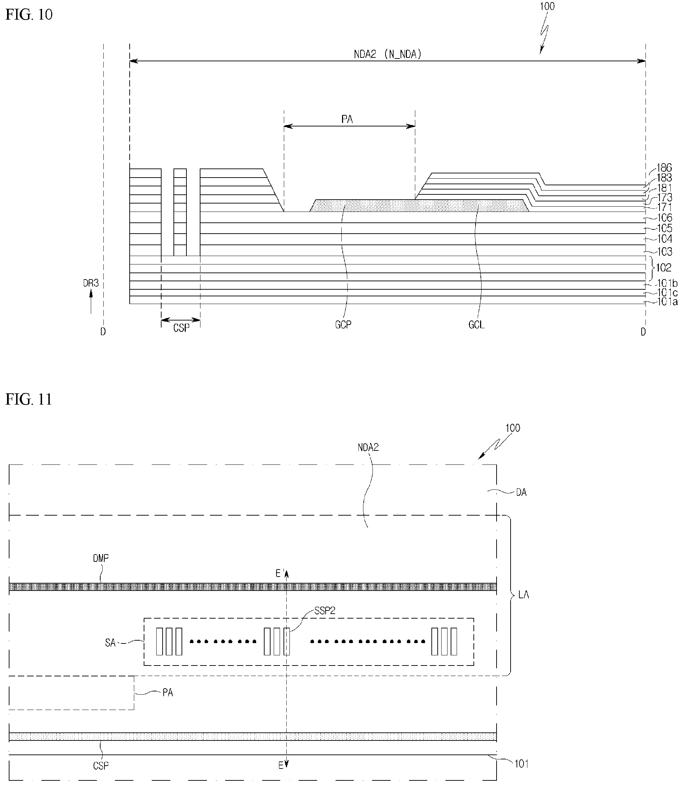

FIG. 8 is a cross-sectional view along line B-B' in FIG. 3. FIG. 9 is a cross-sectional view along line C-C' in FIG. 3. FIG. 10 is a cross-sectional view along line D-D' in FIG. 3.

FIGS. 8 to 10 illustrate cross-sectional structures of the second non-display area NDA2.

FIGS. 8 to 10 illustrate cross sections of the notch non-display area N_NDA of the second non-display area NDA2, but the descriptions thereof may be applied to the extension non-display area E_NDA in the substantially the same manner. However, the embodiments of the specification are not limited thereto, and the notch non-display area N_NDA and the extension non-display area E_NDA may have different cross-sectional structures.

Referring to FIGS. 3, 5, and 8 to 10, in the notch non-display area N_NDA, the display panel 100 may include the substrate 101, the buffer layer 102, the first insulating layer 103, the second insulating layer 104, the third insulating layer 105, the fourth insulating layer 106, the first protective layer 111, the second protective layer 112, the bank 154, the encapsulation part 170, the touch buffer layer 181, the first touch insulating layer 183, and the third touch insulating layer 186 that are sequentially disposed.

In the notch non-display area N_NDA, the display panel 100 may further include the high-potential voltage line VDDL, the low-potential voltage line VSSL, the dam part DMP, a plurality of pads VSSP, VDDP, and DP disposed in the pad area PA, the data line DL (DL1 and DL2), and the crack prevention pattern CSP.

The high-potential voltage line VDDL may be disposed on the buffer layer 102 and covered by the first insulating layer 103 in the non-display area NDA. The high-potential voltage line VDDL may include the same material as the first light-shielding layer 126 and may be formed together using one mask by the same process as the first light-shielding layer 126, but is not limited thereto.

Although not illustrated, the high-potential voltage pad VDDP may be disposed on the same layer as the source electrode 121 and the drain electrode 124, may include the same material as the source electrode 121 and the drain electrode 124, and may be formed together using one mask by the same process as the source electrode 121 and the drain electrode 124, but is not limited thereto.

In this case, the high-potential voltage pad VDDP may be electrically connected in contact with the high-potential voltage line VDDL through the contact hole S_CNT that exposes the high-potential voltage line VDDL.

The high-potential voltage line VDDL may further include the high-potential connection electrode (not illustrated). The high-potential connection electrode (not illustrated) may be disposed on a different layer from the high-potential voltage line VDDL. For example, the high-potential connection electrode (not illustrated) may be disposed between the second insulating layer 104 and the third insulating layer 105. The high-potential connection electrode (not illustrated) may electrically connect the high-potential voltage line VDDL to the anode electrode 151 across the lines disposed on the same layer as the high-potential voltage line VDDL. The high-potential connection electrode (not illustrated) may be electrically connected to the anode electrode 151 across the lines disposed on the same layer as the high-potential voltage line VDDL.

When the high-potential voltage line VDDL is formed on the same layer as the high-potential voltage pad VDDP and formed integrally therewith, a high-potential connection electrode (not illustrated) disposed on a different layer from the high-potential voltage pad VDDP may be further included. The high-potential connection electrode (not illustrated) may electrically connect the high-potential voltage line VDDL to the anode electrode 151 across the lines disposed on the same layer as the high-potential voltage line VDDL.

The first data pad DP1 and the second data pad DP2 may be disposed on the fourth insulating layer 106. The first data pad DP1 and the second data pad DP2 may be disposed on the same layer as the source electrode 121 and the drain electrode 124, may include the same material as the source electrode 121 and the drain electrode 124, and may be formed together using one mask by the same process as the source electrode 121 and the drain electrode 124, but are not limited thereto.

The first data line DL1 may be disposed on the second insulating layer 104 and covered by the third insulating layer 105 in the non-display area NDA. The first data line DL1 may include the same material as the gate electrode 122 and may be formed together using one mask by the same process as the gate electrode 122, but is not limited thereto.

The display panel 100 may further include a first data connection line (not illustrated). The first data connection line (not illustrated) may be disposed on a different layer from the first data line DL1 and may electrically connect the first data line DL1 to the thin film transistor 120 of the display area DA.

The second data line DL2 may be disposed on the third insulating layer 105 and covered by the fourth insulating layer 106 in the non-display area NDA. The second data line DL2 may include the same material as the second storage electrode 142 and may be formed together using one mask by the same process as the second storage electrode 142, but is not limited thereto.

The display panel 100 may further include a second data connection line (not illustrated). The second data connection line (not illustrated) may be disposed on a different layer from the second data line DL2 and may electrically connect the second data line DL2 to the thin film transistor 120 of the display area DA.

The first data line DL1 may be electrically connected in contact with the first data pad DP1 through the first data contact hole CNT1. The second data line DL2 may be electrically connected in contact with the second data pad DP2 through the second data contact hole CNT2.

The first data line DL1 and the second data line DL2 may be insulated by the third insulating layer 105 and disposed alternately. For example, the first data line DL1 and the second data line DL2 adjacent to each other may be disposed and extended on different layers in the link area LA, thereby reducing or minimizing the bezel area.

The first data line DL1 may be formed of the same material as the first electrode of the storage electrode on the same layer as the first electrode of the storage electrode, and the second data line may be formed of the same material as the second electrode of the storage electrode on the same layer as the second electrode of the storage electrode.

The gate control pad GCP may include the same material as the gate control line GCL, but is not limited thereto. The gate control pad GCP and the gate control line GCL may be formed integrally, but are not limited thereto.

For example, the gate control pad GCP and the gate control line GCL may be disposed on the fourth insulating layer 106 in the non-display area NDA. The gate control pad GCP and the gate control line GCL may be disposed on the same layer as the source electrode 121 (see FIG. 5) and the drain electrode 124 (see FIG. 5) and may include the same material as the source electrode 121 and the drain electrode 124, and the gate control pad GCP, the gate control line GCL, the source electrode 121, and the drain electrode 124 may be formed together using one mask by the same process, but the embodiments of the specification are not limited thereto.

The gate control pad GCP and the gate control line GCL may be formed of different materials. For example, the gate control pad GCP may be disposed on the fourth insulating layer 106, and the gate control line GCL may be disposed on the second insulating layer 104 like the first data line DL1 and covered by the third insulating layer 105 or disposed on the third insulating layer 105 like the second data line DL2 and covered by the fourth insulating layer 106 in the non-display area NDA.

The crack prevention pattern CSP may be disposed outside the pad area PA. The crack prevention pattern CSP may be disposed between the ends of the pad area PA and the non-display area NDA2.

At least some of the inorganic films disposed on the substrate 101 may extend to the end of the non-display area NDA2. For example, at least some of the inorganic films disposed on the substrate 101 in the notch non-display area N_NDA and the extension non-display area E_NDA may extend to the end of the substrate 101.

In the notch non-display area N_NDA, the buffer layer 102, the first insulating layer 103, the second insulating layer 104, the third insulating layer 105, the fourth insulating layer 106, the first inorganic encapsulation layer 171, the second inorganic encapsulation layer 173, the touch buffer layer 181, the first touch insulating layer 183, and the third touch insulating layer 186 may extend to the end of the substrate 101.

In the notch non-display area N_NDA, the buffer layer 102, the first insulating layer 103, the second insulating layer 104, the third insulating layer 105, the fourth insulating layer 106, the first inorganic encapsulation layer 171, the second inorganic encapsulation layer 173, the touch buffer layer 181, the first touch insulating layer 183, and the third touch insulating layer 186 may cover substantially the entire area of the substrate 101 excluding the pad area PA.

The ends (or side surfaces) of the substrate 101, the buffer layer 102, the first insulating layer 103, the second insulating layer 104, the third insulating layer 105, the fourth insulating layer 106, the first inorganic encapsulation layer 171, the second inorganic encapsulation layer 173, the touch buffer layer 181, the first touch insulating layer 183, and the third touch insulating layer 186 may be aligned, but are not limited thereto.

However, the plurality of pads VSSP, VDDP, and DP may not be covered by a plurality of inorganic films. The plurality of inorganic films disposed on the fourth insulating layer 106 may expose the plurality of pads VSSP, VDDP, and DP. The plurality of inorganic films disposed on the fourth insulating layer 106 may not be disposed in the pad area PA.

For example, the first inorganic encapsulation layer 171, the second inorganic encapsulation layer 173, the touch buffer layer 181, the first touch insulating layer 183, and the third touch insulating layer 186 may be disposed up to the end of the substrate 101 in the notch non-display area N_NDA, but may not be disposed in the pad area PA. Accordingly, the plurality of pads VSSP, VDDP, and DP disposed on the fourth insulating layer 106 may be exposed, and the display panel 100 may be adhered to the flexible film COF and electrically connected to the flexible film COF.

However, the embodiments of the specification are not limited thereto, and in the extension non-display area E_NDA, at least one of the buffer layer 102, the first insulating layer 103, the second insulating layer 104, the third insulating layer 105, the fourth insulating layer 106, the first inorganic encapsulation layer 171, the second inorganic encapsulation layer 173, the touch buffer layer 181, the first touch insulating layer 183, and the third touch insulating layer 186 may not extend to the end of the substrate 101.

For example, in the extension non-display area E_NDA, the buffer layer 102, the first insulating layer 103, the second insulating layer 104, the third insulating layer 105, and the fourth insulating layer 106 may extend to the end of the substrate 101, the first inorganic encapsulation layer 171 and the second inorganic encapsulation layer 173 may extend only to the dam part DMP, and the touch buffer layer 181, the first touch insulating layer 183, and the third touch insulating layer 186 may extend until before the dam part DMP. For example, the buffer layer 102, the first insulating layer 103, the second insulating layer 104, the third insulating layer 105, and the fourth insulating layer 106 may be disposed between the dam part DMP and the crack prevention pattern CSP, and the first inorganic encapsulation layer 171, the second inorganic encapsulation layer 173, the touch buffer layer 181, the first touch insulating layer 183, and the third touch insulating layer 186 may not be disposed. However, the plurality of pads VSSP, VDDP, DP, and GCP may not be covered by the plurality of inorganic films. The plurality of inorganic films disposed on the fourth insulating layer 106 may expose the plurality of pads VSSP, VDDP, DP, and GCP. The plurality of inorganic films disposed on the fourth insulating layer 106 may not be disposed in the pad area PA.

For example, the first inorganic encapsulation layer 171, the second inorganic encapsulation layer 173, the touch buffer layer 181, the first touch insulating layer 183, and the third touch insulating layer 186 may be disposed up to the end of the substrate 101 in the notch non-display area N_NDA, but may not be disposed in the pad area PA. Accordingly, the plurality of pads VSSP, VDDP, DP, and GCP disposed on the fourth insulating layer 106 may be exposed, and the display panel 100 may be adhered to the flexible film COF and electrically connected to the flexible film COF.

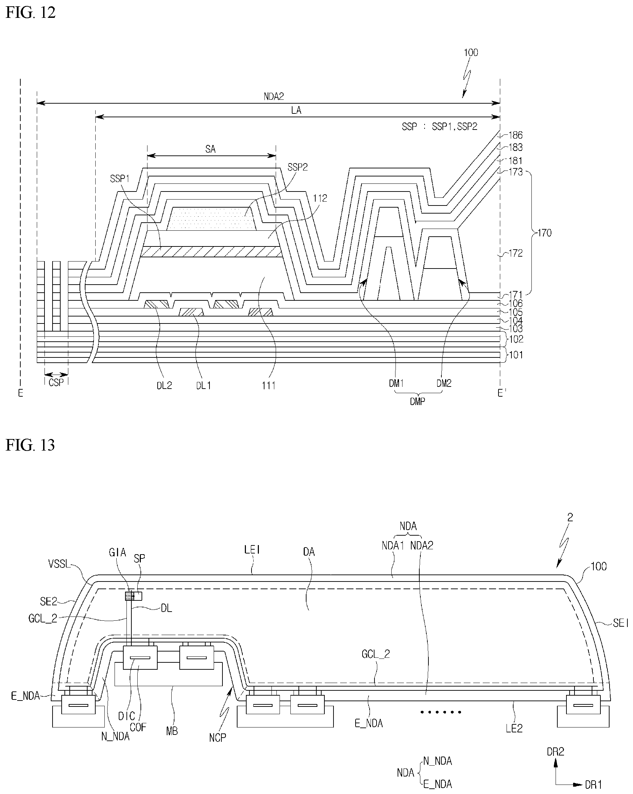

FIG. 11 is a plan view of a notch non-display area of a second non-display area. FIG. 12 is a cross-sectional view along line E-E' in FIG. 11.

Referring to FIGS. 11 and 12, in the notch non-display area N_NDA, a scratch prevention area SA may be further disposed on the link area LA.

In the scratch prevention area SA, the display panel 100 may sequentially include the substrate 101, the buffer layer 102, the first insulating layer 103, the second insulating layer 104, the third insulating layer 105, the fourth insulating layer 106, the first protective layer 111, a first scratch prevention pattern SSP1, the second protective layer 112, a second scratch prevention pattern SSP2, the first inorganic encapsulation layer 171, the second inorganic encapsulation layer 173, the touch buffer layer 181, the first touch insulating layer 183, and the third touch insulating layer 186.

The scratch prevention area SA may be formed in at least a part of the link area LA in which the plurality of data lines DL connected to the data pad DP extend diagonally toward the display area DA. The scratch prevention area SA may be disposed between the pad area PA and the dam part DMP.

In the scratch prevention area SA, the display panel 100 may include a scratch prevention pattern SSP. The scratch prevention pattern SSP may be formed of the first scratch prevention pattern SSP1 and the second scratch prevention pattern SSP2 overlapping the first scratch prevention pattern SSP1.

The first scratch prevention pattern SSP1 may be formed on the first protective layer 111. At least a part of the first scratch prevention pattern SSP1 may be disposed to overlap the first data line DL1 and the second data line DL2 in the link area LA. The first scratch prevention pattern SSP1 may be implemented in the form of a whole metal in the entirety of the scratch prevention area SA. However, the embodiments of the specification are not limited thereto, and the first scratch prevention pattern SSP1 may be implemented in the form of a whole metal or implemented in the form of a plurality of islands in some areas.

The first scratch prevention pattern SSP1 may be formed of the same material as the connection electrode 145 on the same layer as the connection electrode 145. The first scratch prevention pattern SSP1 and the connection electrode 145 may be formed together using one mask by the same process, but are not limited thereto.

The second scratch prevention pattern SSP2 may be formed on the second protective layer 112. At least a part of the second scratch prevention pattern SSP2 may be disposed to overlap the first data line DL1 and the second data line DL2 in the link area LA. The second scratch prevention pattern SSP2 may be implemented in a bar shape or implemented in the form of a plurality of islands in the link area LA.

The second scratch prevention pattern SSP2 may be formed of the same material as the spacer 155 on the same layer as the spacer 155. The second scratch prevention pattern SSP2 and the spacer 155 may be formed together using one mask by the same process, but are not limited thereto.

The second scratch prevention pattern SSP2 may be formed to be covered by the first inorganic encapsulation layer 171. For example, in the scratch prevention area SA, at least a part of the first inorganic layer 171 may be formed to come into contact with the second protective layer 112 and formed to cover an upper surface and the side surfaces of the second scratch prevention pattern SSP2.

In this way, the display panel 100 may be implemented to have the design of the display panel 100 including the notch NCP by including the scratch prevention area SA in which the scratch prevention pattern SSP is formed, and a user can receive improved aesthetic feeling and convenience. It is possible to suppress and prevent a stabbing or scratching defect of the display panel 100 due to mask sagging that may occur in the notch NCP due to a manufacturing process. Furthermore, it is possible to prevent defects, increase the life, and reduce production energy of the display apparatus 1.

FIG. 13 is a plan view of a display apparatus of another embodiment.

Referring to FIG. 13, in a display apparatus 2 of the embodiment, a separate gate driving unit GIP (see FIG. 1) may not be disposed in the non-display area NDA, and a pixel gate driving unit GIA may be disposed in the display area DA.

The pixel gate driving unit GIA may be provided as a plurality of pixel gate driving units, and each pixel gate driving unit GIA may be connected to each of the plurality of sub-pixels SP. The pixel gate driving unit GIA may be disposed between adjacent sub-pixels SP.

For example, the pixel gate driving unit GIA may be disposed between the adjacent sub-pixels SP in the first direction DR1. The sub-pixel SP and the pixel gate driving unit GIA may be alternately repeatedly disposed in the first direction DR1. The sub-pixel SP may be continuously and repeatedly disposed in the second direction DR2. The pixel gate driving unit GIA may be continuously repeatedly disposed in the second direction DR2.

The pixel gate driving unit GIA may perform substantially the same role as the gate driving unit GIP (see FIG. 1). The pixel gate driving unit GIA may include at least one transistor.

The pixel gate driving unit GIA may be electrically connected to an adjacent sub-pixel SP.

The pixel gate driving unit GIA may receive a gate control signal from the drive IC DIC through a gate control line GCL_2. The pixel gate driving unit GIA may generate a scan signal and a light-emitting signal (or a light-emitting control signal) based on the gate control signal. Accordingly, the driving of the adjacent sub-pixel SP may be controlled.

Since the pixel gate driving unit GIA is disposed in the display area DA, it is possible to minimize the non-display area NDA or the bezel area, thereby providing improved aesthetic feeling to a user.

The features, structures, effects, etc. described above in the examples of the specification are included in at least one example of the specification and are not necessarily limited to only one example. Furthermore, the features, structures, effects, etc. illustrated in at least one example of the specification may be implemented by being combined or modified in other examples by those skilled in the art to which the specification pertains. Accordingly, the contents related to such combination and modification should be construed as being included in the scope of the specification.

The specification is not limited to the above-described embodiments and the accompanying drawings, and it will be apparent to those skilled in the art to which the present specification pertains that various substitutions, modifications, and changes are possible without departing from the technical matters of the specification. Accordingly, the scope of the specification is determined by the appended claims, and all changes or modified forms derived from the meaning and scope of the claims and their equivalent concepts should be construed as being included in the scope of the specification.

### DESCRIPTION OF REFERENCE NUMERALS

| | | | |
|---|---|---|---|
| 1: | display apparatus | PA: | pad area |
| 100: | display panel | LA: | link area |
| 101: | substrate | SA: | scratch prevention area |
| NCP: | notch | SP: | sub-pixel |
| DA: | display area | EA: | light-emitting area |
| NDA: | non-display area | NEA: | non-light-emitting area |
| NDA1: | first non-display area | ML: | microlens |
| NDA2: | second non-display area | 150: | light emitting part |
| N_NDA: | notch non-display area | 170: | encapsulation part |
| E_NDA: | extension non-display area | | |

## Claims

1. A display apparatus (1) comprising:
a substrate (101) having a notch (NCP) and including a display area (DA) including a plurality of sub-pixels (SP) and a non-display area (NDA) adjacent or around the display area (DA);
a plurality of transistors (120, G120) disposed on the substrate (101);
a display panel (100) including a light-emitting part (150) disposed on the plurality of transistors (120, G120); and
a microlens (ML) disposed on light-emitting areas (EA) of the sub-pixels (SP),
a pad part (PA) and a link part (LA) disposed in the non-display area (NDA), and
a plurality of data lines (DL) of which some are formed on different layers with an insulating layer interposed therebetween are alternately disposed in the link part (LA).

2. The display apparatus of claim 1, wherein a metal layer (SSP1, SSP2) is disposed in link part (LA) above the plurality of data lines (DL), preferably the metal layer (SSP1, SSP2) is implemented in form of a whole metal in an entirety of the link part (LA) or in form of a plurality of islands in the link part (LA).

3. The display apparatus of claim 2, further comprising a spacer (155) overlapping the metal layer (SSP1, SSP2), preferably the spacer (155) is formed to correspond to the metal layer (SSP1, SSP2) in a bar type or a form of a plurality of islands.

4. The display apparatus of any one of the preceding claims, further comprising a storage electrode including a first electrode (141) formed on the same layer as a gate electrode (122) of the transistor (120) and a second electrode (142) corresponding to the first electrode (141).

5. The display apparatus of any one of the preceding claims, wherein the plurality of data lines (DL) include a first data line (DL1), and a second data line (DL2) formed of a different material from the first data line (DL1), preferably the first data line (DL1) is formed on the same layer as the gate electrode (122) of the transistor (120) and/or preferably the second data line (DL2) is formed on the same layer as the second electrode (142) of the storage electrode.

6. The display apparatus of any one of the preceding claims, wherein at least one printed circuit film is attached to the pad part (PA).

7. The display apparatus of any one of the preceding claims, further comprising a voltage line (VSSL, VDDL) and a gate control line (GCL) that are electrically connected to the pad part (PA), preferably the voltage line (VSSL, VDDL) intersects the gate control line (GCL) or the plurality of data lines (DL).

8. The display apparatus of any one of the preceding claims, wherein the substrate (101) further includes a dam (DMP) and a crack prevention part (CSP), preferably the pad part (PA) and the link part (LA) are disposed between the dam (DMP) and the crack prevention part (CSP).

9. The display apparatus of claim 8, wherein the dam (DMP) overlaps the voltage line (VSSL, VDDL) and surrounds the display area (DA) and/or the crack prevention part (CSP) is formed by recessing at least one insulating layer at an outermost edge of the non-display area (NA).

10. The display apparatus of any one of the preceding claims, wherein a center of the microlens (ML) and a center of the light-emitting area (EA) are misaligned.

11. The display apparatus of any one of the preceding claims, wherein an anode electrode (151) of the light-emitting part (150) is tilted toward the microlens (ML).

12. The display apparatus of any one of the preceding claims, wherein the plurality of sub-pixels (SP) include a first pixel group (PXG1) in which a center of the microlens (ML) is misaligned to the other side in a first direction compared to a center of the light-emitting area (EA), and a second pixel group (PXG2) in which the center of the microlens (ML) is misaligned to one side in the first direction compared to the center of the light-emitting area (EA).

13. The display apparatus of any one of the preceding claims, wherein the non-display area (NDA) further includes a gate driving unit between the voltage line (VSSL, VDDL) and the display area (DA).

14. The display apparatus of any one of the preceding claims 7-13, further comprising a pixel gate driving unit (GIA) located in the display area (DA), wherein the pad part (PA) and the pixel gate driving unit (GIA) are electrically connected through the gate control line (GCL).

15. The display apparatus of any one of the preceding claims, wherein the display panel (100) includes a first long edge (LE1), a second long edge (LE2), and a first short edge (SE1) and a second short edge (SE2) that connect the first long edge (LE1) to the second long edge (LE2), and the second long edge (LE2) is longer than the first long edge (LE1).
